(19) Europäisches Patentamt
European Patent Office
Office européen des brevets

(11) Veröffentlichungsnummer: **0 255 486 B1**

(12) **EUROPÄISCHE PATENTSCHRIFT**

(45) Veröffentlichungstag der Patentschrift: **16.06.93**

(51) Int. Cl.$^5$: **C07F 17/00**, C08F 2/50, G03F 7/027

(21) Anmeldenummer: **87810430.6**

(22) Anmeldetag: **27.07.87**

Die Akte enthält technische Angaben, die nach dem Eingang der Anmeldung eingereicht wurden und die nicht in dieser Patentschrift enthalten sind.

# (54) Titanocene und deren Verwendung.

(30) Priorität: **01.08.86 CH 3101/86**

(43) Veröffentlichungstag der Anmeldung:
**03.02.88 Patentblatt 88/05**

(45) Bekanntmachung des Hinweises auf die Patenterteilung:
**16.06.93 Patentblatt 93/24**

(84) Benannte Vertragsstaaten:
**BE CH DE FR GB IT LI NL SE**

(56) Entgegenhaltungen:
**EP-A- 0 119 162**
**EP-A- 0 122 223**
**EP-A- 0 186 626**
**EP-A- 0 207 893**

(73) Patentinhaber: **CIBA-GEIGY AG**
**Klybeckstrasse 141**
**CH-4002 Basel(CH)**

(72) Erfinder: **Riediker, Martin, Dr.**
**Gstaltenrainweg 75**
**CH-4125 Riehen(CH)**
Erfinder: **Steiner, Eginhard, Dr.**
**Obere Hofaackerstrasse 3**
**CH-4414 Füllinsdorf(DE)**
Erfinder: **Beyeler, Harry**
**Marignanostrasse 35**
**CH-4059 Basel(CH)**
Erfinder: **Rembold, Manfred, Dr.**
**Im Aeschfeld 21**
**CH-4147 Aesch(CH)**
Erfinder: **Sitek, Franciszek, Dr.**
**Grossmattweg 11**
**CH-4106 Therwil(CH)**



Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft Titanocene mit fluorierten aromatischen Resten, eine photopolymerisierbare Zusammensetzung aus äthylenisch ungesättigten Verbindungen, die diese Titanocene als Photoinitiatoren enthalten, ein mit dieser Zusammensetzung beschichtetes Substrat und ein Verfahren zur Herstellung photographischer Reliefabbildungen unter Verwendung dieses beschichteten Substrates.

Aus der EP-A-0 122 223 ist es bekannt, dass Titanocene mit Fluorarylliganden ausgezeichnete Photoinitiatoren sind. Diese Titanocene sind kristallin und daher anwendungstechnisch nicht immer problemlos zu verarbeiten. Die mit diesen Titanocenen erzielbaren Lichtempfindlichkeiten werden durch deren Löslichkeiten in lichtempfindlichen Zusammensetzungen beeinflusst.

Gegenstand der vorliegender Erfindung sind Titanocene der Formel I

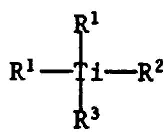

(I),

worin beide $R^1$ unabhängig voneinander gegebenenfalls ein- oder mehrfach durch $C_1$-$C_{18}$-Alkyl oder -Alkoxy, $C_2$-$C_{18}$-Alkenyl, $C_5$-$C_8$-Cycloalkyl, $C_6$-$C_{16}$-Aryl, $C_7$-$C_{16}$-Aralkyl, Cyan oder Halogen substituiertes Cyclopentadienyl$^{\ominus}$, Indenyl$^{\ominus}$, 4,5,6,7-Tetrahydroindenyl$^{\ominus}$ bedeuten oder beide $R^1$ zusammen für einen gegebenenfalls wie zuvor substituierten Rest der Formel II

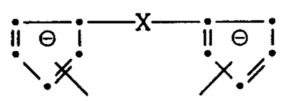

(II)

stehen, worin X $-(CH_2)_n$ mit n = 1, 2 oder 3, gegebenenfalls durch Phenyl substituiertes Alkyliden mit 2 bis 12 C-Atomen, Cycloalkyliden mit 5 bis 7 Ringkohlenstoffatomen, $SiR^4_2$ oder $SnR^4_2$ ist, und $R^4$ $C_1$-$C_{12}$-Alkyl, $C_5$-$C_{12}$-Cycloalkyl, $C_6$-$C_{16}$-Aryl oder $C_7$-$C_{16}$-Aralkyl bedeutet,
$R^2$ einen 6-gliedrigen carbocyclischen oder 5- oder 6-gliedrigen heterocyclischen aromatischen Ring bedeutet, der in mindestens einer der beiden ortho-Stellungen zur Metallkohlenstoffbindung durch Fluoratome substituiert ist und wobei der aromatische Ring als weitere Substituenten $C_1$-$C_{18}$-Alkyl, $C_5$-$C_6$-Cycloalkyl, $C_6$-$C_{16}$-Aryl, $C_7$-$C_{16}$-Aralkyl, Hydroxyl, $C_1$-$C_{18}$-Alkoxy, Carboxyl, $C_1$-$C_{18}$-Alkoxycarbonyl, Halogen oder Cyano enthalten kann, oder $R^2$ und $R^3$ zusammen einen Rest der Formel III bedeuten,

$$—Q—Y—Q— \quad (III)$$

in dem Q für einen carbocyclischen aromatischen Ring steht, wobei die beiden Bindungen jeweils in Orthostellung zur Y-Gruppe stehen und die Metastellung zur Y-Gruppe jeweils durch ein Fluoratom substituiert ist und wobei Q als weitere Substituenten $C_1$-$C_{18}$-Alkyl, $C_5$-$C_6$-Cycloalkyl, $C_6$-$C_{16}$-Aryl, $C_7$-$C_{16}$-Aralkyl, Hydroxyl, $C_1$-$C_{18}$-Alkoxy, Carboxyl, $C_1$-$C_{18}$-Alkoxycarbonyl, Halogen oder Cyano enthalten kann, und Y $CH_2$, Alkyliden mit 2 bis 12 C-Atomen, Cycloalkyliden mit 5 bis 7 Ringkohlenstoffatomen, eine direkte Bindung, $NR^4$, O, S, SO, $SO_2$, CO, $SiR^4_2$ oder $SnR^4_2$ bedeutet und $R^4$ die zuvor angegebene Bedeutung hat,
$R^3$ die Bedeutung von $R^2$ hat oder $C_2$-$C_6$-Alkinyl, mit Halogen, tertiär-Amino, $C_1$-$C_6$-Alkoxy, Carboxyl, OH oder CN substituiertes oder unsubstituiertes Phenylalkinyl, $N_3$, CN, $SiR^4_3$ oder $SnR^4_3$ bedeutet, wobei die Titanocene dadurch gekennzeichnet sind, dass $R^2$ und/oder $R^3$, sofern dieser Rest eine Bedeutung, wie für $R^2$ definiert ist, hat, und, falls $R^2$ und $R^3$ einen Rest der Formel III bilden, Q mindestens einen gegebenenfalls verätherten oder veresterten Polyoxaalkylenrest der Formel

$$-(C_zH_{2z}O)_o-R^9$$

enthält, worin z eine Zahl von 2-6, o eine Zahl von 1-20 und $R^9$ H, $C_1$-$C_{18}$-Alkyl oder $C_1$-$C_{18}$-Acyl bedeutet, wobei dieser Rest entweder direkt oder über eine Brückengruppe an den aromatischen Ring gebunden sein

kann, wobei es sich bei der Brückengruppe um eine Gruppe der Formel -S-, -O-, $-OSO_2-$, $-CH_2O-$, $-CH(CH_3)O-$, $-SO_2-$, -C(O)O-,

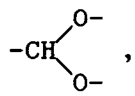

-N< , $-NR^{10}-$,

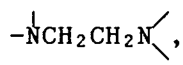

$-NR^{10}CH_2CH_2N<$ ,

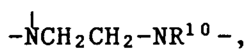

$-NR^{10}CH_2CH_2NR^{10}-$, $-CH_2N<$ , $-CH_2NR^{10}-$, $-CH(COO-)_2$, $-CH_2COO-$, $-CONR^{10}-$, $-CH(CONR^{10}-)_2$, $-CH_2CONR^{10}-$, -CON< , -OC(O)O-, $-N(R^{10})-COO-$, $-CH_2N(R^{10})-COOH-$, $-N(R^{10})-CONH-$, $-CH_2N(R^{10})-CONH-$, $C_nH_{2n}OC(O)C_mH_{2m}O-$ mit n = 0, 1 oder 2 und m = 1-6,

$$-C_nH_{2n}OSiR^{11}_{3-y}O\!-_y$$

mit n = 0, 1 oder 2 und y = 1-3,

$$-OCH_2CH_2OSiR^{11}_{3-y}O\!-_y,\quad -COOSiR^{11}_{3-y}O\!-_y$$

oder

$$-CH_2COOSiR^{11}_{3-y}O\!-_y$$

mit y = 1-3 handelt, worin $R^{10}$ H, $C_1$-$C_{18}$-Alkyl oder $C_1$-$C_{18}$-Acyl und $R^{11}$ $C_1$-$C_{12}$-Alkyl oder Phenyl sind.

Bei den Gruppen $R^1$ handelt es sich bevorzugt um gleiche Reste. Als Substituenten kommen für $R^1$ in Frage: lineares oder verzweigtes Alkyl oder Alkoxy mit 1 bis 18, besonders 1 bis 12 und insbesondere 1 bis 6 C-Atomen, und Alkenyl mit 2 bis 18, besonders 2 bis 12, und insbesondere 2 bis 6 C-Atomen, wie z.B. Methyl, Ethyl, Propyl, Isopropyl, n-Butyl, tert.-Butyl, Pentyl, Hexyl, Octyl, Decyl, Dodecyl, Tetradecyl, Hexadecyl, Octadecyl und entsprechende Alkenyl- und Alkoxygruppen; Cycloalkyl und Cycloalkenyl mit 5 bis 8 Ringkohlenstoffatomen wie z.B. Cyclopentyl, Cyclohexyl, Cycloheptyl, Methylpentyl und Methylcyclohexyl; Aryl mit 6 bis 16 C-Atomen und Aralkyl mit 7 bis 16 C-Atomen wie z.B. Phenyl, Naphthyl, Benzyl und Phenyläthyl; Nitril und Halogen, besonders F, Cl und Br.

Die Reste $R^1$ können bis zu 3, besonders aber 1, Substituenten enthalten. Insbesondere sind beide $R^1$ Cyclopentadienyl$^{\ominus}$- oder Methylcyclopentadienyl$^{\ominus}$-Reste.

X in Formel II enthält in seiner Bedeutung als Alkyliden bevorzugt 2 bis 6 C-Atome. Beispiele für Alkyliden, das gegebenenfalls durch Phenyl substituiert sein kann, und Cycloalkyliden sind Ethyliden, Propyliden, Butyliden, Hexyliden, Phenylmethylen, Diphenylmethylen, Cyclopentyliden und Cyclohexyliden. $R^4$ in der Gruppe X in seiner Bedeutung als Alkyl enthält bevorzugt 1 bis 6 C-Atome, und ist z.B. Methyl, Ethyl, Propyl, Butyl oder Hexyl, und ist in seiner Bedeutung als Cycloalkyl bevorzugt Cyclopentyl oder Cyclohexyl, in seiner Bedeutung als Aryl bevorzugt Phenyl und in seiner Bedeutung als Aralkyl bevorzugt Benzyl. Besonders bevorzugt ist X Methylen.

$R^2$ als heterocyclischer aromatischer und 5-gliedriger Rest enthält bevorzugt ein Heteroatom und als 6-gliedriger Ring bevorzugt 1 oder 2 Heteroatome.

Die Gruppe $R^2$ enthält mindestens einen gegebenenfalls verätherten oder veresterten (Polyoxaalkylen)-rest, wobei dieser Rest direkt oder über eine Brückengruppe an den aromatischen Ring gebunden sein

kann. Sie kann weitere Ringsubstituenten enthalten, wie z.B. Alkyl, Cycloalkyl, Aryl, Aralkyl, Hydroxyl, Alkoxy, Carboxyl, Alkoxycarbonyl, Halogen oder Cyano. Beispiele hierfür sind: lineares oder verzweigtes Alkyl oder Alkoxy mit bevorzugt 1 bis 18, insbesondere 1 bis 6 C-Atomen, z.B. Methyl, Ethyl, Propyl, Butyl, Pentyl, Hexyl und die entsprechenden Alkoxygruppen, besonders Methyl und Methoxy; Cycloalkyl mit bevorzugt 5 oder 6 Ringkohlenstoffatomen, Aryl mit bevorzugt 6 bis 16 C-Atomen und Aralkyl mit bevorzugt 7 bis 16 C-Atomen wie z.B. Cyclopentyl, Cyclohexyl, Phenyl oder Benzyl; Hydroxyl, Carboxyl, CN, Halogen, wie F, Cl oder Br und tertiäres Amino, das mit Alkylhalogeniden, wie Methylchlorid, -bromid oder -jodid quaternisiert sein kann. Beispiele für Amino sind Dimethylamino, Pyrrolidyl, Piperidyl, Piperazyl, Morpholyl, N-Methylpiperazyl; Alkoxycarbonyl mit bevorzugt 1 bis 18, besonders 1 bis 6 C-Atomen in der Alkoxygruppe; Aminocarbonyl mit ein oder zwei Alkylgruppen mit 1 bis 12 C-Atomen in der Aminogruppe oder Aminocarbonyl mit heterocyclischen Aminen, wie Pyrrolidin, Piperidin, Piperazin, N-Nethylpiperazin und Morpholin; tertiäres Aminoalkyl mit bevorzugt $C_1$-$C_6$-Alkylgruppen, das mit Alkylhalogeniden quaternisiert sein kann.

$R^3$ enthält in seiner Bedeutung als Alkinyl bevorzugt 2 bis 6 C-Atome. Beispiele sind Ethinyl und Propargyl. Als Phenylalkinyl ist $R^3$ bevorzugt Phenylethinyl. Substituenten für $R^3$ als Phenylalkinyl sind z.B. Halogen, wie F, Cl, Br, tertiär-Amino und Alkoxy mit 1 bis 6 C-Atomen, Carboxyl, OH und CN. $R^3$ hat bevorzugt die Bedeutung von $R^2$.

In einer bevorzugten Ausführungsform ist in Formel I $R^2$ substituiertes 2,6-Difluorphen-1-yl oder $R^2$ und $R^3$ zusammen ein substituierter Rest der Formel

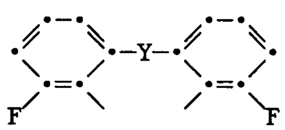

,

worin Y die zuvor angegebene Bedeutung hat, die durch mindestens einen gegebenenfalls verätherten oder veresterten (Polyoxaalkylen)rest substituiert sind, wobei dieser Rest direkt oder über eine Brückengruppe an $R^2$ gebunden sein kann. Insbesondere ist $R^2$ 2,6-Difluorphen-1-yl, das 1 bis 3 weitere Substituenten enthält, wovon mindestens einer ein gegebenenfalls verätherter oder veresterter (Polyoxalkylen)rest ist, der direkt oder über eine Brückengruppe an $R^2$ gebunden ist.

Eine bevorzugte Ausführungsform ist dadurch gekennzeichnet, dass $R^2$ und $R^3$ für 2,6-Difluorphen-1-yl stehen, an das mindestens ein gegebenenfalls verätherter Polyoxaalkylenrest direkt oder über eine Brückengruppe gebunden ist, und das weitere 1 oder 2 gleiche oder verschiedene Substituenten enthalten kann.

Eine bevorzugte Gruppe von Metallocenen der Formel I sind solche, worin beide $R^1$ Cyclopentadienyl$^{\ominus}$ oder durch $C_1$-$C_4$-Alkyl substituiertes Cyclopentadienyl$^{\ominus}$ und $R^2$ und $R^3$ Reste der Formel

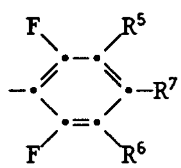

sind, worin $R^5$ und $R^6$ unabhängig voneinander H, F, Cl oder Br bedeuten und $R^7$ gegebenenfalls veräthertes oder verestertes Polyoxaalkylen ist, das direkt oder über eine Brückengruppe an den Phenylring gebunden ist. $R^5$ und $R^6$ sind bevorzugt F.

Der Polyoxaalkylenrest ist bevorzugt mit $C_1$-$C_{18}$-, besonders $C_1$-$C_{12}$- und insbesondere $C_1$-$C_6$-Alkyl veräthert oder mit $C_1$-$C_{18}$-, besonders $C_1$-$C_{12}$- und insbesondere $C_1$-$C_6$-Acyl verestert. Beispiele für Alkyl sind Methyl, Ethyl, n-und i-Propyl, n-, i- und t-Butyl, Pentyl, Hexyl, Heptyl, Octyl, Nonyl, Decyl, Undecyl, Dodecyl, Tetradecyl, Hexadecyl, Octadecyl. Beispiele für Acyl sind Formyl, Acetyl, Propionyl, Trifluoracetyl, Butyryl, Pentanoyl, Hexanoyl, Octanoyl, Dodecanoyl, Benzoyl. Bevorzugt sind verätherte Polyoxaalkylenreste.

Der Polyoxaalkylenrest enthält bevorzugt 1 bis 20, besonders 1 bis 12 und insbesondere 2 bis 6 Oxaalkyleneinheiten. Das Alkylen im (Polyoxaalkylen)rest enthält bevorzugt 2 bis 6, besonders 2 bis 4 C-Atome und stellt insbesondere Ethylen oder 1,2-Propylen dar. Weitere Beispiele sind 1,3-Propylen, 1,2-,

1,3- und 1,4-Butylen, Pentylen und Hexylen. Im Polyoxaalkylenrest können auch verschiedene Alkylenreste enthalten sein.

In einer bevorzugten Ausführungsform stellen $R^9$ $C_1$-$C_{12}$-Alkyl, $R^{10}$ H oder $C_1$-$C_{12}$-Alkyl und $R^{11}$ $C_1$-$C_6$-Alkyl, z eine Zahl von 2 bis 4 und o eine Zahl von 2 bis 6 dar.

In einer besonders bevorzugten Gruppe der erfindungsgemässen Titanocene entspricht der über eine Brückengruppe gebundene Polyoxaalkylenrest den Formeln

$$-O-(CH_2CH_2O)_o-R^9$$

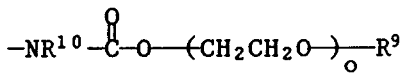

$$-N[(CH_2CH_2-O)_o-R^9]_2$$

$$-NR^{10}(CH_2CH_2O)_o-R^9$$

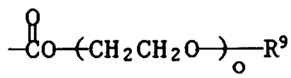

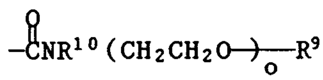

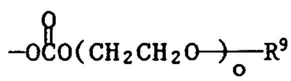

worin $R^9$ $C_1$-$C_{12}$-Alkyl bedeutet, $R^{10}$ H oder $C_1$-$C_6$-Alkyl darstellt und o für eine Zahl von 2 bis 6 steht.

Besonders bevorzugt sind Titanocene der Formel I, worin $R^1$ Cyclopentadienyl oder Methylcyclopentadienyl ist und $R^2$ und $R^3$ Reste der Formel

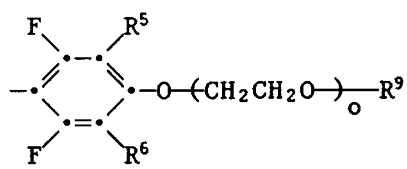

sind, worin $R^5$ und $R^6$ Wasserstoff oder Fluor bedeuten, o eine Zahl von 2-6 bedeutet und $R^9$ $C_1$-$C_{12}$-Alkyl bedeutet, insbesondere solche, worin $R^5$ und $R^6$ Fluor bedeuten.

Beispiele für Titanocene der Formel I sind:
Bis(cyclopentadienyl)-bis[4-(1′,4′,7′-trioxaundecyl)-2,3,5,6-tetrafluorphenyl]-titan,
Bis(methylcyclopentadienyl)-bis[4-(1′,4′,7′-trioxaundecyl)-2,3,5,6-tetrafluorphenyl]-titan,
Bis(cyclopentadienyl)-bis[4-(1′,4′,7′,10′-tetraoxadodecyl)-2,3,5,6-tetrafluorphenyl]-titan,
Bis(methylcyclopentadienyl)-bis[3-(1′,4′,7′-trioxahendecyl)-2,6-difluorphenyl]-titan,
Bis(cyclopentadienyl)-bis[3-(1′,4′,7′,10′-trioxadodecyl)-2,6-difluorphenyl]-titan,
Bis(cyclopentadienyl)-bis[3-(1′,4′-dioxapentyl)-2,6-difluorphenyl]-titan.

Die Herstellung der Titanocene der Formel I kann nach bekannten oder analogen Verfahren erfolgen, indem man 1 Mol einer Verbindung der Formel III

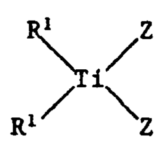 (III),

worin $R^1$ die angegebene Bedeutung hat und Z für Halogen, besonders Chlor, steht, entweder mit ein Mol $LiR^2$ oder $LiR^3$ und danach mit ein Mol $LiR^3$ bzw. $LiR^2$ umsetzt, oder mit 2 Mol $LiR^2$ umsetzt, wobei $R^2$ die

zuvor angegebene Bedeutung hat und $R^3$ Alkinyl, unsubstituiertes oder substituiertes Phenylalkinyl, $N_3$, CH, $SiR^4{}_3$ oder $SnR^4{}_3$ bedeutet, und danach die Verbindungen der Formel I in an sich bekannter Weise isoliert.

Die bekannten Verfahren sind z.B. in J. Organometal. Chem., 2 (1964) 206-212, J. Organometal. Chem., 4 (1965) 445-446 und in der EP-A-0 122 223 beschrieben.

Die Ausgangsverbindungen der Formel III, in denen Z besonders für Chlor steht, sind bekannt oder können nach analogen Verfahren durch die Umsetzung von $TiCl_4$ mit Natriumverbindungen $NaR^1$ erhalten werden. Die Lithiumverbindungen $LiR^2$ und $LiR^3$ sind ebenfalls bekannt oder können nach analogen Verfahren durch die Umsetzung von $R^2$- bzw. $R^3$-Halogeniden, besonders den Bromiden, mit Butyllithium hergestellt werden. Mit Tertiäraminomethylgruppen substituierte Derivate erhält man z.B. durch die Umsetzung von entsprechenden Difluordibromphenylverbindungen, die man zunächst in Lithiumdifluorbromphenylverbindungen überführt, danach mit N,N-Dialkylmethylenammoniumchlorid umsetzt, worauf das entstandene Dialkylaminomethyl-difluorbromphenyl mit Butyllithium zur entsprechenden Lithiumverbindung umgesetzt wird.

Die Einführung des gegebenenfalls verätherten oder veresterten Polyoxaalkylenrestes in die $R^2$-Halogenide erfolgt in an sich bekannter Weise. Funktionelle $R^2$-Halogenide, die geeignete Vorläufer für Brückengruppen aufweisen, sind z.B. von L.S. Kobrina in Fluorine chemistry revious, Volume 7, S. 1-114, Marcel Dekker Inc., NY, 1974 beschrieben.

Die Herstellung der Metallocene der Formel I erfolgt im allgemeinen in Gegenwart inerter Lösungsmittel wie z.B. Kohlenwasserstoffen oder Aethern, bei Temperaturen unter -30 bis -100 °C, vorzugsweisse -60 bis -90 °C und unter Schutzgasatmosphäre. In einer Ausführungsform des Verfahrens wird zunächst $LiR^2$ bzw. $LiR^3$ durch Umsetzung der entsprechenden Halogenide in Aether als Lösungsmittel mit Lithiumbutyl bei Temperaturen um -78 °C hergestellt. Zu der gekühlten Reaktionsmischung gibt man dann das entsprechende Titanocendihalogenid, entfernt die Kühlung und lässt auf Raumtemperatur erwärmen. Die Reaktionsmischung wird dann, gegebenenfalls nach Zugabe von Lösungsmitteln, filtriert und aus der Lösung durch Ausfällen oder Verdampfen des Lösungsmittels das erfindungsgemässe Titanocen isoliert.

Es handelt sich im allgemeinen um flüssige, sirupöse bis harzartige, meist orange-gefärbte Verbindungen, die sich durch eine hohe thermische Stabilität auszeichnen und sich erst bei hohen Temperaturen zersetzen. Auch unter Lufteinwirkung sowie unter Einwirkung von Wasser wird keine Zersetzung beobachtet. Die Verbindungen können sehr gut in härtbaren Zusammensetzungen gelöst werden bzw. mit diesen vermischt werden, auch in höheren Mengen, und bieten daher wertvolle anwendungstechnische Vorteile. Die Verbindungen sind auch in Lösungsmitteln sehr gut löslich, und können in Form von Lösungen in härtbare Zuammensetzungen eingearbeitet werden, wonach das Lösungsmittel gegebenenfalls entfernt wird.

Die Verbindungen sind dunkellagerstabil und können ohne Schutzgas gehandhabt werden. Sie eignen sich alleine hervorragend als sehr wirksame Photoinitiatoren für die lichtinduzierte Polymerisation ethylenisch ungesättigter Verbindungen. Sie zeichnen sich hierbei durch eine sehr hohe Lichtempfindlichkeit und Wirksamkeit über einen grossen Wellenlängenbereich von ca. 200 nm (UV-Licht) bis etwa 600 nm aus. Ferner vermögen die Titanocene auch wirksam die Polymerisation unter dem Einfluss von Wärme zu initiieren, wobei ein Erwärmen auf 170 °C bis 240 °C zweckmässig ist. Selbstverständlich kann auch Lichteinwirkung und Erwärmung zur Polymerisation benutzt werden, wobei eine Erwärmung nach der Belichtung tiefere Temperaturen, z.B. 80-150 °C, zur Polymerisation erlaubt.

Ein weiterer Gegenstand vorliegender Erfindung ist eine durch Strahlung polymerisierbare Zusammensetzung, enthaltend (a) mindestens eine nichtflüchtige, monomere, oligomere oder polymere Verbindung mit mindestens einer polymerisierbaren ethylenisch ungesättigten Doppelbindung und (b) mindestens ein Titanocen der Formel I als Photoinitiator.

Die Zusammensetzungen können weitere Photoinitiatoren (c), z.B. solche vom Typ der Benzilketale, 4-Aroyl-1,3-dioxolane, Dialkoxyacetophenone, $\alpha$-Hydroxy- oder $\alpha$-Aminoacetophenone oder Mischungen davon enthalten. Der Vorteil besteht darin, dass man geringere Mengen der erfindungsgemässen Titanocene verwenden kann und trotzdem gleiche oder verbesserte Lichtempfindlichkeiten erzielen kann. Das Gewichtsverhältnis dieser Komponenten (c):(b) kann z.B. von 1:1 bis 30:1, bevorzugt 5:1 bis 15:1 betragen.

Die Zusatzmenge der erfindungsgemässen Titanocene richtet sich im wesentlichen nach wirtschaftlichen Gesichtspunkten, deren Löslichkeiten und nach der gewünschten Empfindlichkeit. Im allgemeinen werden 0,01 bis 20, vorzugsweise 0,05-10 und besonders 0,1 bis 5 Gew.% verwendet, bezogen auf die Komponente (a).

Als Komponente (a) kommen solche ethylenisch ungesättigten monomeren, oligomeren und polymeren Verbindungen in Frage, die durch Photopolymerisation zu höhermolekularen Produkten reagieren und hierbei ihre Löslichkeit verändern.

Besonders geeignet sind z.B. Ester von ethylenisch ungesättigten Carbonsäuren und Polyolen oder Polyepoxiden, und Polymere mit ethylenisch ungesättigten Gruppen in der Kette oder in Seitengruppen, wie z.B. ungesättigte Polyester, Polyamide und Polyurethane und Copolymere hiervon, Polybutadien und Butadien-Copolymere, Polyisopren und Isopren-Copolymere, Polymere und Copolymere mit (Meth)-Acylgruppen in Seitenketten, sowie Mischungen von einem oder mehreren solcher Polymerer.

Beispiele für ungesättigte Carbonsäuren sind Acrylsäure, Methacrylsäure, Crotonsäure, Itaconsäure, Zimtsäure, ungesättigte Fettsäuren wie Linolensäure oder Oelsäure. Bevorzugt sind Acryl- und Methacrylsäure.

Als Polyole sind aromatische und besonders aliphatische und cycloaliphatische Polyole geeignet. Beispiele für aromatische Polyole sind Hydrochinon, 4,4′-Dihydroxydiphenyl, 2,2-Di(4-hydroxyphenyl)-propan, sowie Novolake und Resole. Beispiele für Polyepoxide sind solche auf der Basis der genannten Polyole, besonders der aromatischen Polyole und Epichlorhydrin. Ferner sind auch Polymere oder Copolymere, die Hydroxylgruppen in der Polymerkette oder in Seitengruppen enthalten, wie z.B. Polyvinylalkohol und Copolymere davon oder Polymethacrylsäurehydroxyalkylester oder Copolymere davon, als Polyole geeignet. Weitere geeignete Polyole sind Oligoester mit Hydroxylendgruppen.

Beispiele für aliphatische und cycloaliphatische Polyole sind Alkylendiole mit bevorzugt 2 bis 12 C-Atomen, wie Ethylenglykol, 1,2- oder 1,3-Propandiol, 1,2-, 1,3 oder 1,4-Butandiol, Pentandiol, Hexandiol, Octandiol, Dodecandiol, Diethylenglykol, Triethylenglykol, Polyethylenglykole mit Molekulargewichten von bevorzugt 200 bis 1500, 1,3-Cyclopentandiol, 1,2-, 1,3- oder 1,4-Cyclohexandiol, 1,4-Dihydroxymethylcyclohexan, Glycerin, Tris-(β-hydroxyethyl)amin, Trimethylolethan, Trimethylolpropan, Pentaerythrit, Dipentaerythrit und Sorbit.

Die Polyole können teilweise oder vollständig mit einer oder verschiedenen ungesättigten Carbonsäuren verestert sein, wobei in Teilestern die freien Hydroxylgruppen modifiziert, z.B. veräthert oder mit anderen Carbonsäuren verestert sein können.

Beispiele für Ester sind:
Trimethylolpropantriacrylat, Trimethylolethantriacrylat, Trimethylolpropantrimethacrylat, Trimethylolethantrimethacrylat, Tetramethylenglykoldimethacrylat, Triethylenglykoldimethacrylat, Tetraethylenglykoldiacrylat, Pentaerythritdiacrylat, Pentaerythrittriacrylat, Pentaerythrittetraacrylat, Dipentaerythritdiacrylat, Dipentaerythrittriacrylat, Dipentaerythrittetraacrylat, Dipentaerythritpentaacrylat, Dipentaerythrithexaacrylat, Tripentaerythritoctaacrylat, Pentaerythritdimethacrylat, Pentaerythrittrimethacrylat, Dipentaerythritdimethacrylat, Dipentaerythrittetramethacrylat, Tripentaerythritoctamethacrylat,Pentaerythritdiitaconat, Dipentaerythrittrisitaconat, Dipentaerythritpentaitaconat, Dipentaerythrithexaitaconat, Ethylenglykoldimethacrylat, 1,3-Butandioldiacrylat, 1,3-Butandioldimethacrylat, 1,4-Butandioldiitaconat, Sorbittriacrylat, Sorbittetraacrylat, Sorbittetramethacrylat, Sorbitpentaacrylat, Sorbithexaacrylat, Oligoesteracrylate und -methacrylate, Glyzerindi- und -triacrylat, 1,4-Cyclohexandiacrylat, Bisacrylate und Bismethacrylate von Polyethylenglykol mit Molekulargewicht von 200-1500, oder Gemische davon.

Als Komponente (a) sind auch die Amide gleicher oder verschiedener ungesättigter Carbonsäuren von aromatischen, cycloaliphatischen und aliphatischen Polyaminen mit bevorzugt 2 bis 6, besonders 2 bis 4 Aminogruppen geeignet. Beispiele für solche Polyamine sind Ethylendiamin, 1,2- oder 1,3-Propylendiamin, 1,2-, 1,3-oder 1,4-Butylendiamin, 1,5-Pentylendiamin, 1,6-Hexylendiamin, Octylendiamin, Dodecylendiamin, 1,4-Diaminocyclohexan, Isophorondiamin, Phenylendiamin, Bisphenylendiamin, Di-β-aminoethylether, Diethylentriamin, Triethylentetramin, Di-(β-aminoethoxy)- oder Di(β-aminopropoxy)-ethan. Weitere geeignete Polyamine sind Polymere und Copolymere mit Aminogruppen in der Seitenkette und Oligoamide mit Aminoendgruppen.

Beispiele für solche ungesättigten Amide sind: Methylen-bis-acrylamid, 1,6-Hexamethylen-bis-acrylamid, Diethylentriamin-tris-methacrylamid, Bis(methacrylamidopropoxy)-ethan, β-Methacrylamidoethylmethacrylat,N[(β-Hydroxyethoxy)ethyl]-acrylamid.

Geeignete ungesättigte Polyester und Polyamide leiten sich z.B. von Maleinsäure und Diolen oder Diaminen ab. Die Maleinsäure kann teilweise durch andere Dicarbonsäuren ersetzt sein. Sie können zusammen mit ethylenisch ungesättigten Comonomeren, z.B. Styrol, eingesetzt werden. Die Polyester und Polyamide können sich auch von Dicarbonsäuren und ethylenisch ungesättigten Diolen oder Diaminen ableiten, besonders von längerkettigen mit z.B. 6 bis 20 C-Atomen. Beispiele für Polyurethane sind solche, die aus gesättigten oder ungesättigten Diisocyanaten und ungesättigten bzw. gesättigten Diolen aufgebaut sind.

Polybutadien und Polyisopren und Copolymere davon sind bekannt. Geeignete Comonomere sind z.B. Polyolefine wie Ethylen, Propen, Buten, Hexen, (Meth)Acrylate, Acrylnitril, Styrol oder Vinylchorid.

Polymere mit (Meth)Acrylatgruppen in der Seitenkette sind ebenfalls bekannt. Es kann sich z.B. um Umsetzungsprodukte von Epoxidharzen auf Novolakbasis mit (Meth)Acrylsäure handeln, um Homo- oder

Copolymere des Polyvinylalkohols oder deren Hydroxyalkylderivaten, die mit (Meth)Acrylsäure verestert sind, oder um Homo- und Copolymere von (Meth)Acrylaten, die mit Hydroxyalkyl(meth)acrylaten verestert sind.

Die photopolymerisierbaren Verbindungen können alleine oder in beliebigen Mischungen eingesetzt werden. Bevorzugt werden Gemische von Polyol-(Meth)Acrylaten verwendet.

Den erfindungsgemässen Zusammensetzungen können auch Bindemittel zugesetzt werden, was besonders zweckmässig ist, wenn es sich bei den photopolymerisierbaren Verbindungen um flüssige oder viskose Substanzen handelt. Die Menge des Bindemittels kann z.B. 5-95, vorzugsweise 10-90 und besonders 50-90 Gew.% betragen, bezogen auf die gesamte Zusammensetzung. Die Wahl des Bindemittels erfolgt je nach dem Anwendungsgebiet und hierfür geforderter Eigenschaften wie Entwickelbarkeit in wässrigen und organischen Lösungsmittelsystemen, Adhäsion auf Substraten und Sauerstoffempfindlichkeit.

Geeignete Bindemittel sind z.B. Polymere mit einem Molekulargewicht von etwa 5000-2 000 000, bevorzugt 10 000 bis 1 000 000. Beispiele sind: Homo- und copolymere Acrylate und Methacrylate, z.B. Copolymere aus Methylmethacrylat/Ethylacrylat/Methacrylsäure, Poly(methacrylsäurealkylester),Poly-(acrylsäurealkylester); Celluloseester und -ether wie Cellulsoeacetat, Celluloseacetatbutyrat, Methylcellulose, Ethylcellulose; Polyvinylbutyral, Polyvinylformal, cyclisierter Kautschuk, Polyether wie Polyethylenoxid, Polypropylenoxid, Polytetrahydrofuran; Polystyrol, Polycarbonat, Polyurethan, chlorierte Polyolefine, Polyvinylchlorid, Copolymere aus Vinylchlorid/Vinylidenchlorid, Copolymere von Vinylidenchlorid mit Acrylnitril, Methylmethacrylat und Vinylacetat, Polyvinylacetat, Copoly(ethylen/vinylacetat), Polyamide wie Polycaprolactam und Poly(hexamethylenadipamid), Polyester wie Poly(äthylenglykolterephthalat) und Poly-(hexamethylenglykolsuccinat).

Die erfindungsgemässen Zusammensetzungen eignen sich als Beschichtungsmittel für Substrate aller Art, z.B. Holz, Papier, Keramik, Kunststoffe, wie Polyester und Celluloseacetatfilme, und Metalle, wie Kupfer und Aluminium, bei denen durch Photopolymerisation eine Schutzschicht oder eine photographische Abbildung aufgebracht werden soll. Ein weiterer Gegenstand vorliegender Erfindung sind die beschichteten Substrate und ein Verfahren zum Aufbringen photographischer Abbildungen auf den Substraten.

Die Beschichtung der Substrate kann erfolgen, indem man eine flüssige Zusammensetzung, eine Lösung oder Suspension auf das Substrat aufbringt. Flüssige Zusammensetzungen ohne Lösungsmittel sind bevorzugt. Hierbei kann es zweckmässig sein, die erfindungsgemässen Titanocene in Form eines flüssigen Photoinitiatorengemisches, enthaltend andere Photoinitiatoren, z.B. ein Benzilketal, ein 4-Aroyl-1,3-dioxolan, ein Dialkoxyacetophenon, ein α-Hydroxy- oder α-Aminoacetophenon oder Mischungen hiervon einzusetzen. Besonders vorteilhaft sind flüssige Mischungen aus flüssigen bis festen Photoinitiatoren und flüssigen Titanocenen oder flüssigen Photoinitiatoren und sirupösen bis festen Titanocenen. Diese Gemische bieten anwendungstechnische Vorteile und zeichnen sich durch eine hohe Dunkellagerstabilität aus.

Beispiele für Benzilketale sind solche der Formel

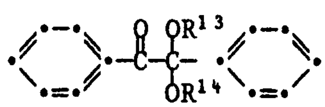

$R^{13} = R^{14}$ = $-CH_3$
$-CH_2CH_3$
$-(CH_2)_2CH_3$
$-(CH_2)_3CH_3$
$-CH_2CH_2CH(CH_3)_2$

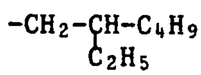

$-(CH_2)_9CH_3$
$-C_{10}H_{21}$-iso
$-C_{12}H_{25}$-n
$-C_9H_{19}$ bis $-C_{11}H_{23}$-Gemisch
$-C_{12}$-$H_{25}$-bis-$C_{15}H_{31}$-Gemisch
$-CH_2CH=CH_2$
$-CH(CH_3)CH=CH_2$

$-CH_2CH_2OC_3H_7$-iso
$-CH_2CH_2OC_4H_9$
$-CH_2CH_2OCH_2CH=CH_2$
$-CH(CH_3)-CH_2OC_4H_9$
$-CH_2COOCH_3$
$-CH_2COOC_4H_9$
$-CH(CH_3)COOCH_3$
$-CH_2CH_2COOC_2H_5$
$-CH(CH_3)CH_2COOCH_3$
$-CH_2CH_2CH(CH_3)OCH_3$

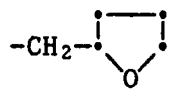

$-(CH_2CH_2O)_2CH_3$
$-(CH_2CH_2O)_2C_2H_5$
$-(CH_2CH_2O)_2C_4H_9$
$-(CH_2CH_2O)_3CH_3$
$-(CH_2CH_2O)_3C_2H_5$
$-(CH_2CH_2O)_3C_{12}H_{25}$
$-(CH_2CH_2O)_5C_{10}H_{21}$
$-(CH_2CH_2O)_8C_9H_{19}$-bis-$C_{11}H_{23}$ (Gemisch)

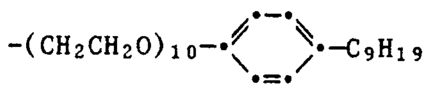

$-CH_2CH_2N(C_2H_5)_2$

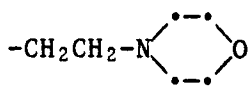

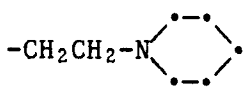

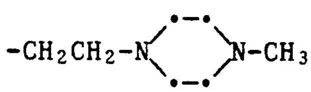

$R^{14} = CH_3$, $R^{13} = C_6H_{13}$
$R^{14} = CH_3$, $R^{13} = C_{10}H_{21}$
$R^{14} = CH_3$, $R^{13} = (CH_2CH_2O)_3-C_{12}H_{25}$ bis-$C_{15}H_{31}$ (Gemisch)
$R^{14} = CH_3$, $R^{13} = (CH_2CH_2O)_5-C_9H_{19}$ bis $-C_{11}H_{23}$ (Gemisch)
$R^{14} = CH_3$, $R^{13} =$

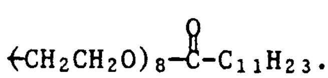

Beispiele für 4-Aroyl-1,3-dioxolane sind:
4-Benzoyl-2,2,4-trimethyl-1,3-dioxolan
4-Benzoyl-4-methyl-2,2-tetramethylen-1,3-dioxolan
4-Benzoyl-4-methyl-2,2-pentamethylen-1,3-dioxolan
cis-trans 4-Benzoyl-2,4-dimethyl-2-methoxymethyl-1,3-dioxolan

cis-trans 4-Benzoyl-4-methyl-2-phenyl-1,3-dioxolan
4-(4-Methoxybenzoyl)-2,2,4-trimethyl-1,3-dioxolan
4-(4-Methoxybenzoyl)-4-methyl-2,2-pentamethylen-1,3-dioxolan
4-(4-Methylbenzoyl)-2,2,4-trimethyl-1,3-dioxolan
cis-trans 4-Benzyol-2-methyl-4-phenyl-1,3-dioxolan
4-Benzoyl-2,2,4,5,5-pentamethyl-1,3-dioxolan
cis-trans 4-Benzoyl-2,2,4,5-tetramethyl-1,3-dioxolan
cis-trans 4-Benzoyl-4-methyl-2-pentyl-1,3-dioxolan
cis-trans 4-Benzoyl-2-benzyl-2,4-dimethyl-1,3-dioxolan
cis-trans 4-Benzoyl-2-(2-furyl)-4-methyl-1,3-dioxolan
cis-trans 4-Benzoyl-5-phenyl-2,2,4-trimethyl-1,3-dioxolan
4-(4-Methoxybenzoyl)-2,2,4,5,5-pentamethyl-1,3-dioxolan.

Beispiele für Dialkoxyacetophenone sind:

α,α-Dimethoxyacetophenon
α,α-Diethoxyacetophenon
α,α-Di-isopropoxyacetophenon
α,α-Di-(2-methoxyethoxy)acetophenon
α-Butoxy-α-ethoxyacetophenon
α,α-Dibutoxy-4-chloracetophenon
α,α-Diethoxy-4-fluoracetophenon
α,α-Dimethoxy-4-methylacetophenon
α,α-Dimethoxy-4-methylacetophenon
α,α-Dimethoxypropiophenon
α,α-Diethoxypropiophenon
α,α-Diethoxybutyrophenon
α,α-Dimethoxyisovalerophenon
α,α-Diethoxy-α-cyclohexylacetophenon
α,α-Dipropoxy-4-chlorpropiophenon.

Beispiele für α-Hydroxy- und α-Aminoacetophenone sind:

2-Hydroxy-2-methyl-1-phenyl-propanon-1
2-Hydroxy-2-ethyl-1-phenylhexanon-1
1-(4-Dodecylphenyl)-2-hydroxy-2-methylpropanon-1
1-(2,4-Dimethylphenyl)-2-hydroxy-2-methylpropanon-1
2-Hydroxy-1-(4-methoxyphenyl)-2-methylpropanon-1
2-Hydroxy-2-methyl-1-phenylbutanon-1
2-Dimethylamino-2-methyl-1-phenylpropanon-1
2-Dibutylamino-2-methyl-1-phenylpropanon-1
1-(4-Fluorphenyl)-2-methyl-2-morpholinopentanon-1
2-Methyl-1-(4-methylthiophenyl)-2-morpholinobutanon-1
2-Dimethylamino-1-(4-methoxyphenyl)-2-methylpropanon-1
2-Diethylamino-1-(4-diethylaminophenyl)-2-methylpropanon-1.

Das Photoinitiatorengemisch (b) + (c) kann in Mengen von 0,5-20, vorzugsweise 1 bis 10 Gew.-%, zugegeben werden, bezogen auf die Komponente (a).

Die Wahl des Lösungsmittels und die Konzentration richtet sich hauptsächlich nach der Art der Zusammensetzung und nach dem Beschichtungsverfahren. Die Zusammensetzung wird mittels bekannter Beschichtungsverfahren auf ein Substrat gleichförmig aufgebracht, z.B. durch Tauchen, Rakelbeschichtung, Vorhanggiessverfahren, Elektrophorese, Aufpinseln, Sprayen oder Reverseroll-Beschichtung. Die Auftragsmenge (Schichtdicke) und Art des Substrates (Schichtträger) sind abhängig vom gewünschten Applikationsgebiet. Als Schichtträger photographische Informationsaufzeichnung dienen z.B. Folien aus Polyester, Celluloseacetat oder mit Kunststoff beschichtete Papiere; für Offsetdruckformen speziell behandeltes Aluminium und für die Herstellung gedruckter Schaltungen kupferkaschierte Laminate. Die Schichtdicken für photographische Materialien und Offsetdruckformen betragen im allgemeinen ca. 0,5 bis ca. 10 µm; für gedruckte Schaltungen im allgemeinen 1 bis ca. 100 µm. Bei Mitverwendung von Lösungsmitteln werden diese nach dem Beschichten entfernt.

Photohärtbare Zusammensetzungen, wie sie für die verschiedenen Zwecke verwendet werden, enthalten meist ausser den photopolymerisierbaren Verbindungen und den Photoinitiatoren eine Reihe sonstiger Zusätze. So ist es vielfach üblich, thermische Inhibitoren zuzusetzen, die vor allem während der Herstellung der Zusammensetzungen durch Mischen der Komponenten vor einer vorzeitigen Polymerisation schützen

sollen. Hierzu werden beispielsweise Hydrochinon, Hydrochinonderivate, p-Methoxyphenol, $\beta$-Naphthole oder sterisch gehinderte Phenole wie z.B. 2,6-Di(tert-butyl)-p-kresol verwendet. Weiter können geringe Mengen von UV-Absorbern zugesetzt werden, wie z.B. solche vom Benztriazol-, Benzophenon- oder Oxalanilid-Typ. Ebenso lassen sich Lichtschutzmittel vom Typus sterisch gehinderter Amine (HALS) zusetzen.

Zur Erhöhung der Dunkellagerstabilität können Kupferverbindungen, wie Kupfernaphthenat, -stearat, oder -octoat, Phosphorverbindungen, wie Triphenylphosphin, Tributylphosphin, Triäthylphosphit, Triphenylphosphit oder Tribenzylphosphit, quaternäre Ammoniumverbindungen, wie Tetramethylammoniumchlorid oder Trimethyl-benzylammoniumchlorid oder Hydroxylaminderivate, wie z.B. N-Diäthylhydroxylamin, zugesetzt werden.

Um die inhibierende Wirkung des Luftsauerstoffs auszuschliessen setzt man photohärtbaren Gemischen häufig Paraffin oder ähnliche wachsartige Stoffe zu. Diese schwimmen bei Beginn der Polymerisation wegen mangelnder Löslichkeit im Polymeren aus und bilden eine transparente Oberflächenschicht, die den Zutritt von Luft verhindert.

Weitere übliche Zusätze sind Photosensibilisatoren, welche in bestimmten Wellenlängen absorbieren und die absorbierte Energie an den Initiatoren weitergeben oder selbst als zusätzlicher Initiator fungieren. Beispiele hierfür sind vor allem Thioxanthon-, Anthracen-, Anthrachinon- und Cumarinderivate.

Weitere übliche Zusätze sind Beschleuniger vom Amin-Typ, die vor allem in pigmentierten Zubereitungen von Bedeutung sind, da sie als Kettenüberträger wirken. Beispiele hierfür sind N-Methyldiäthanolamin, Triäthylamin, p-Dimethylaminobenzoesäureäthylester oder Michler's Keton. Die Wirkung der Amine kann verstärkt werden durch den Zusatz von aromatischen Ketonen vom Benzophenontyp.

Weitere übliche Zusätze sind z.B. Füllstoffe, Pigmente, Farbstoffe, Haft-, Netz- und Verlaufmittel.

Grosse Bedeutung hat die Photohärtung für Druckfarben, da die Trocknungszeit des Bindemittels ein massgeblicher Faktor für die Produktionsgeschwindigkeit graphischer Erzeugnisse ist und in der Grössenordnung von Bruchteilen von Sekunden liegen soll. Insbesondere für den Siebdruck sind UV-härtbare Druckfarben von Bedeutung.

Gut geeignet sind die erfindungsgemässen photohärtbaren Zusammensetzungen auch zur Herstellung von Druckplatten, insbesondere Flexodruckplatten. Hierbei werden z.B. Gemische von löslichen linearen Polyamiden oder von Styrol-Butadien-Kautschuk mit photopolymerisierbaren Monomeren, beispielsweise Acrylamiden oder Acrylaten, und einem Photoinitiator verwendet. Filme und Platten aus diesen Systemen werden über das Negativ (oder Positiv) der Druckvorlage belichtet und die ungehärteten Anteile anschliessend mit einem Lösungsmittel eluiert.

Ein weiteres Einsatzgebiet der Photohärtung ist die Metallbeschichtung, beispielsweise bei der Lackierung von Blechen für Tuben, Dosen oder Flaschenverschlüssen, sowie die Photohärtung von Kunststoffbeschichtungen, beispielsweise von Fussboden- oder Wandbelägen auf PVC-Basis.

Beispiele für die Photohärtung von Papierbeschichtungen sind die farblose Lackierung von Etiketten, Schallplatten-Hüllen oder Buchumschlägen.

Wichtig ist auch die Verwendung der photohärtbaren Zusammensetzungen für Abbildungsverfahren und zur optischen Herstellung von Informationsträgern. Hierbei wird die auf dem Träger aufgebrachte Schicht (nass oder trocken) durch eine Photomaske mit kurzwelligem Licht bestrahlt und die unbelichteten Stellen der Schicht durch Behandlung mit einem Lösungsmittel (= Entwickler) entfernt. Die belichteten Stellen sind vernetzt-polymer und dadurch unlöslich und bleiben auf dem Träger stehen. Bei entsprechender Anfärbung entstehen sichtbare Bilder. Ist der Träger eine metallisierte Schicht, so kann das Metall nach dem Belichten und Entwickeln an den unbelichteten Stellen weggeätzt oder durch Galvanisieren verstärkt werden. Auf diese Weise lassen sich gedruckte Schaltungen und Photoresists herstellen.

Zur Belichtung eignen sich Lichtquellen mit hohem Anteil an kurzwelligem Licht. Hierfür stehen heute entsprechende technische Vorrichtungen und verschiedene Lampenarten zur Verfügung. Beispiele sind Kohlelichtbogenlampen, Xenonlichtbogenlampen, Quecksilberdampflampen, Metall-Halogenlampen, Fluoreszenzlampen, Argonlampen oder photographische Flutlichtlampen. Neuerdings werden auch Laserlichtquellen verwendet. Diese haben den Vorteil, dass keine Photomasken notwendig sind; der gesteuerte Laserstrahl schreibt direkt auf die photohärtbare Schicht.

Die erfindungsgemässen Titanocene sind mit den Komponenten der photohärtbaren Zusammensetzungen gut vermischbar bzw. in der Zusammensetzung gut löslich, wodurch eine hohe Lichtempfindlichkeit erzielt werden kann.

Die nachfolgenden Beispiele erläutern die Erfindung näher.

Beispiel 1:

a) Diethylenglykol-mono-butyl-mono-(2,3,5,6-tetrafluor-4-chlor)-phenylether

23 g Na-Metall (1 Mol) werden fein geschnitten in 500 ml Diethylenglykol-monobutylether eingetragen, wobei die Temperatur des Gemisches durch externe Kühlung bei ca. 45 °C gehalten wird. Nach dem Abklingen der Reaktion wird auf 50 °C erwärmt, bis das Natrium vollständig gelöst ist. Die braune Lösung wird innert ca. 1 Stunde unter schwacher Kühlung bei 40-45 °C zu 233 g Chlor-pentafluorbenzol (1,16 Mol) zulaufen gelassen. Das Reaktionsgemisch wird auf 70 °C erwärmt und während ca. 7 Stunden bei dieser Temperatur gehalten. Nach dem Erkalten wird es auf 1 l Wasser ausgetragen und mit 1 l Methylenchlorid ausgezogen. Die organische Phase wird abgetrennt, mit $Na_2SO_4$ getrocknet und das Lösungsmittel im Wasserstrahlvakuum abdestilliert. Der Rückstand wird im Hochvakuum rektifiziert und die bei 100-104 °C und 3 mbar siedende Fraktion aufgefangen. Man erhält 280 g eines klaren, farblosen Oels.

b) Bis(cyclopentadienyl)-bis-[4-(1′,4′,7′-trioxa-n-undec-1-yl)-(2,3,5,6-tetrafluorphenyl)]titanocen

51,7 g Diethylenglykol-mono-butyl-mono(2,3,5,6-tetrafluoro-4-chlor)-phenyläther (0,15 Mol) werden in 400 ml absolutem Diethylether unter Argon-Schutzgas gelöst und auf -75 °C abgekühlt. Nach dem Zutropfen von 103 ml Lithiumbutyl-Hexan-Lösung (1,6 molar) wird 15 Minuten bei -75 °C gerührt. Hierauf setzt man 18,7 g Biscyclopentadienyltitandichlorid (0,075 Mol) als Pulver zu und entfernt die Kühlung. Die Mischung erwärmt sich innert ca. 2 Stunden auf Raumtemperatur, wobei eine orangerote trübe Lösung entsteht. Das Reaktionsgemisch wird auf 1 l Wasser aufgegossen und in Portionen mit total 600 ml Ethylacetat ausgezogen. Die organische Phase wird mit $Na_2SO_4$ getrocknet und am Wasserstrahlvakuum eingedampft. Der Rückstand besteht aus 58,0 g eines klaren orangeroten Oels. Dieses Oel kann durch Chromatographie über Kieselgel mit einem 2:1 Hexan-Ethergemisch als Laufmittel gereinigt werden. Das nach dem Abdestillieren der Lösungsmittel resultierende klare zählflüssige orange Oel bleibt auch bei längerem Stehen flüssig.

Beispiel 2:

Ein analoges Produkt mit ähnlichen Eigenschaften kann hergestellt werden, wenn als Titanverbindung eine äquivalente Menge Bis(methylcyclopentadienyl)titandichlorid verwendet und sonst nach obigem Verfahren gearbeitet wird. Man erhält Bis(methylcyclopentadienyl)-bis-[4-(1′,4′,7′-trioxa-n-undec-1-yl)(2,3,5,6-tetrafluorphenyl)]-titanocen als klares zähflüssiges oranges Oel, das auch bei längerem Stehen flüssig bleibt.

Beispiel 3:

Bis(cyclopentadienyl)-bis[4-(1′,4′,7′,10′-tetraoxadodecyl)-2,3,5,6-tetrafluorphenyl]-titan

Wie in Beispiel 1 beschrieben wird Triethylenglykol-monoethylether mit Natrium und Chlorpentafluorbenzol umgesetzt. Der erhaltene Triethylenglykol-monoethyl-mono(2,3,5,6-tetrafluor-4-chlorphenyl)-ether siedet bei 8 mbar bei 124-128 °C. 54,1 g dieses Ethers werden wie in Beispiel 1 beschrieben mit 103 ml Lithiumbutyl-Hexanlösung und 18,7 g Bis(cyclopentadienyl)titandichlorid umgesetzt. Nach chromatographischer Reinigung erhält man die Titelverbindung als klares viskoses orangefarbenes Oel, das auch bei längerem Stehen flüssig bleibt.

Beispiel 4: Photohärtung eines Acrylat-Gemisches

Es wird eine photohärtbare Zusammensetzung hergestellt durch Mischen der folgenden Komponenten:
50 Teile eines Oligourethan-acrylates (Actilan® AJ 20),
20 Teile Trimethylolpropan-triacrylat
15 Teile Tripropylenglykol-diacrylat
15 Teile N-Vinylpyrrolidon
0,5 Teile eines Verlaufshilfsmittels auf Silicon-Basis (BYK® 300, Byk-Mallinckrodt, BRD)
Portionen dieser Zusammensetzung werden mit der in der folgenden Tabelle angegebenen Menge an Photoinitiator oder Initiatorgemisch vermischt. Bei den Initiatorgemischen handelt es sich um Lösungen eines Titanocens in einem flüssigen Initiator vom Ketal-Typ der Formel A:

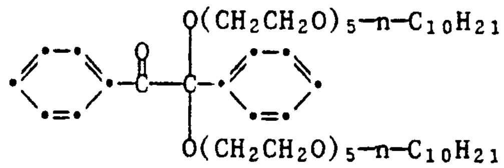

A

Alle Operationen werden unter Rotlicht oder Gelblicht ausgeführt.

Die mit Initiator versetzten Proben werden in einer Stärke von 100 µm auf Aluminiumbleche (10 x 15 cm) aufgetragen. Auf die flüssige Schicht wird eine 76 µm dicke Polyesterfolie gelegt und auf diese ein standardisiertes Testnegativ mit 21 Stufen verschiedener optischer Dichte (Stouffer-Keil) gelegt. Darüber wird eine zweite Polyesterfolie gelegt und das so erhaltene Laminat auf einer Metallplatte fixiert. Die Probe wird dann mit einer 5 KW-Metallhalogenid-Lampe im Abstand von 30 cm belichtet und zwar in einer ersten Testreihe 5 Sekunden und in einer zweiten Testreihe 10 Sekunden und in einer dritten Testreihe 15 Sekunden. Nach der Belichtung werden die Folien und die Maske entfernt, die belichtete Schicht in einem Ethanolbad 15 Sekunden entwickelt und anschliessend bei 60 °C 5 Min getrocknet. Die Empfindlichkeit des verwendeten Initiatorsystems wird durch die Angabe der letzten klebefrei abgebildeten Keilstufe charakterisiert. Je höher die Zahl der Stufen ist, desto empfindlicher ist das System. Eine Erhöhung um zwei Stufen bedeutet dabei etwa eine Verdopplung der Härtungsgeschwindigkeit. Die Ergebnisse sind in Tabelle 1 dargestellt.

Tabelle 1

| Titanocen-Initiator | Ketal-Initiator | Zahl der abgebildeten Stufen nach Belichtung 5s | 10s | 15s |
|---|---|---|---|---|
| 0,2 % Beispiel 1 | - | 11 | 12 | 15 |
| 0,2 % Beispiel 1 | 1,8 % A | 11 | 14 | 16 |
| 0,2 % Beispiel 2 | - | 9 | 11 | 13 |

Beispiel 5:

Es wird eine photohärtbare Zusammensetzung durch Mischen der folgenden Komponenten hergestellt:
150,3 Teile Styrol/Monomethylmaleinat-Copolymer als 30%-ige Lösung in Aceton,
48,3 Teile Trimethylolpropantriacrylat
6,4 Teile Polyethylenglykoldiacrylat
0,16 Teile Kristallviolett.

Es wird weiter wie in Beispiel 4 verfahren. Die Entwicklung wird mit einer wässrig-alkalischen Lösung der folgenden Zusammensetzung vorgenommen:
1000 g Wasser
15 g Natriummetasilikat
0,16 g Kaliumhydroxid
3 g Polyethylenglykol 6000
0,5 g Lävulinsäure
Die Ergebnisse sind in Tabelle 2 dargestellt.

Tabelle 2

| Titanocen-Initiator | Zahl der abgebildeten Stufen nach 20s | 40s | 60s Belichtung |
|---|---|---|---|
| 0,2 % Beispiel 1 | 11 | 14 | 15 |
| 0,2 % Beispiel 2 | 10 | 12 | 14 |

## Patentansprüche

**1.** Titanocene der Formel I

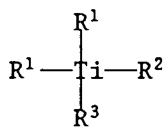

(I),

worin beide $R^1$ unabhängig voneinander gegebenenfalls ein- oder mehrfach durch $C_1$-$C_{18}$-Alkyl oder -Alkoxy, $C_2$-$C_{18}$-Alkenyl, $C_5$-$C_8$-Cycloalkyl, $C_6$-$C_{16}$-Aryl, $C_7$-$C_{16}$-Aralkyl, Cyan oder Halogen substituiertes Cyclopentadienyl$^{\ominus}$, Indenyl$^{\ominus}$, 4,5,6,7-Tetrahydroindenyl$^{\ominus}$ bedeuten oder beide $R^1$ zusammen für einen gegebenenfalls wie zuvor substituierten Rest der Formel II

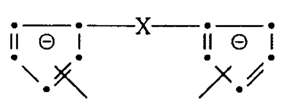

(II)

stehen, worin X $-(CH_2)_n-$ mit n = 1, 2 oder 3, gegebenenfalls durch Phenyl substituiertes Alkyliden mit 2 bis 12 C-Atomen, Cycloalkyliden mit 5 bis 7 Ringkohlenstoffatomen, $SiR^4_2$ oder $SnR^4_2$ ist, und $R^4$ $C_1$-$C_{12}$-Alkyl, $C_5$-$C_{12}$-Cycloalkyl, $C_6$-$C_{16}$-Aryl oder $C_7$-$C_{16}$-Aralkyl bedeutet,
$R^2$ einen 6-gliedrigen carbocyclischen oder 5- oder 6-gliedrigen heterocyclischen aromatischen Ring bedeutet, der in mindestens einer der beiden ortho-Stellungen zur Metallkohlenstoffbindung durch Fluoratome substituiert ist und wobei der aromatische Ring als weitere Substituenten $C_1$-$C_{18}$-Alkyl, $C_5$-$C_6$-Cycloalkyl, $C_6$-$C_{16}$-Aryl, $C_7$-$C_{16}$-Aralkyl, Hydroxyl, $C_1$-$C_{18}$-Alkoxy, Carboxyl, $C_1$-$C_{18}$-Alkoxycarbonyl, Halogen oder Cyano enthalten kann, oder $R^2$ und $R^3$ zusammen einen Rest der Formel III bedeuten,

$-Q-Y-Q-$ (III)

in dem Q für einen carbocyclischen aromatischen Ring steht, wobei die beiden Bindungen jeweils in Orthostellung zur Y-Gruppe stehen und die Metastellung zur Y-Gruppe jeweils durch ein Fluoratom substituiert ist und wobei Q als weitere Substituenten $C_1$-$C_{18}$-Alkyl, $C_5$-$C_6$-Cycloalkyl, $C_6$-$C_{16}$-Aryl, $C_7$-$C_{16}$-Aralkyl, Hydroxyl, $C_1$-$C_{18}$-Alkoxy, Carboxyl, $C_1$-$C_{18}$-Alkoxycarbonyl, Halogen oder Cyano enthalten kann, und Y $CH_2$, Alkyliden mit 2 bis 12 C-Atomen, Cycloalkyliden mit 5 bis 7 Ringkohlenstoffatomen, eine direkte Bindung, $NR^4$, O, S, SO, $SO_2$, CO, $SiR^4_2$ oder $SnR^4_2$ bedeutet und $R^4$ die zuvor angegebene Bedeutung hat,
$R^3$ die Bedeutung von $R^2$ hat oder $C_2$-$C_6$-Alkinyl, mit Halogen, tertiär-Amino, $C_1$-$C_6$-Alkoxy, Carboxyl, OH oder CN substituiertes oder unsubstituiertes Phenylalkinyl, $N_3$, CN, $SiR^4_3$ oder $SnR^4_3$ bedeutet, wobei die Titanocene dadurch gekennzeichnet sind, dass $R^2$ und/oder $R^3$, sofern dieser Rest eine Bedeutung, wie für $R^2$ definiert ist, hat, und, falls $R^2$ und $R^3$ einen Rest der Formel III bilden, Q mindestens einen gegebenenfalls verätherten oder veresterten Polyoxaalkylenrest der Formel

$$-(C_zH_{2z}O)_o-R^9$$

enthält, worin z eine Zahl von 2-6, o eine Zahl von 1-20 und $R^9$ H, $C_1$-$C_{18}$-Alkyl oder $C_1$-$C_{18}$-Acyl bedeutet wobei dieser Rest entweder direkt oder über eine Brückengruppe an den aromatischen Ring gebunden sein kann, wobei es sich bei der Brückengruppe um eine Gruppe der Formel -S-, -O-, $-OSO_2-$, $-CH_2O-$, $-CH(CH_3)O-$, $-SO_2-$, -C(O)O-,

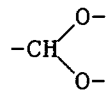 ,

$-N<$ , $-NR^{10}-$,

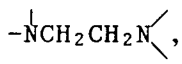 ,

$-NR^{10}CH_2CH_2N<$ ,

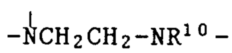 ,

$-NR^{10}CH_2CH_2NR^{10}-$, $-CH_2N<$ , $-CH_2NR^{10}-$, $-CH(COO-)_2$, $-CH_2COO-$, $-CONR^{10}-$, $-CH(CONR^{10}-)_2$, $-CH_2CONR^{10}-$, $-CON<$ , -OC(O)O-, $-N(R^{10})-COO-$, $-CH_2N(R^{10})-COOH-$, $-N(R^{10})-CONH-$, $-CH_2N(R^{10})-CONH-$, $C_nH_{2n}OC(O)C_mH_{2m}O-$ mit n = 0, 1 oder 2 und m = 1-6,

$$-C_nH_{2n}OSiR^{11}_{3-y}O_y-$$

mit n = 0, 1 oder 2 und y = 1-3,

$$-OCH_2CH_2OSiR^{11}_{3-y}O_y-,\quad -COOSiR^{11}_{3-y}O_y-$$

oder

$$-CH_2COOSiR^{11}_{3-y}O_y-$$

mit y = 1-3 handelt, worin $R^{10}$ H, $C_1$-$C_{18}$-Alkyl oder $C_1$-$C_{18}$-Acyl und $R^{11}$ $C_1$-$C_{12}$-Alkyl oder Phenyl sind.

**2.** Titanocene gemäss Anspruch 1, dadurch gekennzeichnet, dass $R^1$ Cyclopentadienyl$^{\ominus}$ oder Methylcyclopentadienyl$^{\ominus}$ ist.

**3.** Titanocene gemäss Anspruch 1, dadurch gekennzeichnet, dass $R^2$ und $R^3$ die gleiche Bedeutung haben.

**4.** Titanocene gemäss Anspruch 1, dadurch gekennzeichnet, dass $R^2$ und $R^3$ für 2,6-Difluorphen-1-yl stehen, an das mindestens ein gegebenenfalls veräthertes Polyoxaalkylenrest direkt oder über eine Brückengruppe gebunden ist, und das weitere 1 oder 2 gleiche oder verschiedene Substituenten enthalten kann.

**5.** Titanocene gemäss Anspruch 4, dadurch gekennzeichnet, dass in Formel I beide $R^1$ Cyclopentadienyl$^{\ominus}$ oder durch $C_1$-$C_4$-Alkyl substituiertes Cyclopentadienyl$^{\ominus}$ und $R^2$ und $R^3$ Reste der Formel

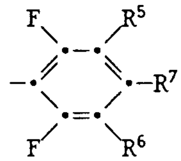

sind, worin $R^5$ und $R^6$ unabhängig voneinander H, F, Cl oder Br bedeuten und $R^7$ gegebenenfalls veräthertes oder verestertes Polyoxaalkylen ist, das direkt oder über eine Brückengruppe an den Phenylring gebunden ist.

**6.** Titanocene gemäss Anspruch 1, dadurch gekennzeichnet, dass der Polyoxaalkylenrest mit $C_1$-$C_{18}$-Alkyl veräthert oder mit $C_1$-$C_{18}$-Acyl verestert ist.

**7.** Titanocene gemäss Anspruch 1, dadurch gekennzeichnet, dass der Polyoxaalkylenrest 1 bis 20 Oxaalkyleneinheiten enthält.

**8.** Titanocene gemäss Anspruch 1, dadurch gekennzeichnet, dass das Alkylen im Polyoxaalkylenrest 2 bis 6 C-Atome enthält.

**9.** Titanocene gemäss Anspruch 8, dadurch gekennzeichnet, dass das Alkylen Ethylen oder 1,2-Propylen ist.

**10.** Titanocene gemäss Anspruch 1, dadurch gekennzeichnet, dass $R^9$ $C_1$-$C_{12}$-Alkyl, $R^{10}$ H oder $C_1$-$C_{12}$-Alkyl und $R^{11}$ $C_1$-$C_6$-Alkyl sind, z für eine Zahl von 2 bis 4 und o für eine Zahl von 2 bis 6 stehen.

**11.** Titanocene gemäss Anspruch 10, dadurch gekennzeichnet, dass der Polyoxaalkylenrest veräthert ist und zusammen mit der Brückengruppe einer der Formeln

$$-O-(CH_2CH_2O)_o-R^9$$

$$-NR^{10}-\overset{O}{\overset{\|}{C}}-O-(CH_2CH_2O)_o-R^9$$

$$-N[(CH_2CH_2-O)_o-R^9]_2$$

$$-NR^{10}(CH_2CH_2O)_o-R^9$$

$$-\overset{O}{\overset{\|}{C}}O-(CH_2CH_2O)_o-R^9$$

$$-\overset{O}{\overset{\|}{C}}-NR^{10}(CH_2CH_2O)_o-R^9$$

$$-O\overset{O}{\overset{\|}{C}}O(CH_2CH_2O)_o-R^9$$

entspricht, worin $R^9$ $C_1$-$C_{12}$-Alkyl bedeutet, $R^{10}$ H oder $C_1$-$C_6$-Alkyl darstellt und o für eine Zahl von 2 bis 6 steht.

**12.** Titanocene gemäss Anspruch 1 der Formel I, worin $R^1$ Cyclopentadienyl$^{\ominus}$ oder Methylcyclopentadienyl$^{\ominus}$ ist und $R^2$ und $R^3$ Reste der Formel

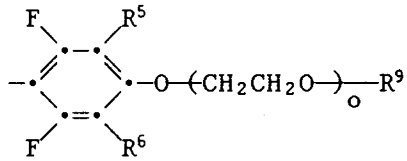

sind, worin $R^5$ und $R^6$ Wasserstoff oder Fluor bedeuten, o eine Zahl von 2 bis 6 bedeutet und $R^9$ $C_1$-$C_{12}$-Alkyl bedeutet.

**13.** Titanocene gemäss Anspruch 12, worin $R^5$ und $R^6$ Fluor sind.

**14.** Verfahren zur Herstellung von Titanocenen der Formel I gemäss Anspruch 1, dadurch gekennzeichnet, dass man 1 Mol einer Verbindung der Formel III

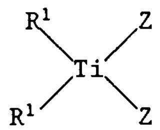

(III),

worin $R^1$ die in Anspruch 1 angegebene Bedeutung hat und Z für Halogen, besonders Chlor, steht, entweder mit ein Mol $LiR^2$ oder $LiR^3$ und danach mit ein Mol $LiR^3$ bzw. $LiR^2$ umsetzt, oder mit 2 Mol $LiR^2$ umsetzt, wobei $R^2$ die in Anspruch 1 angegebene Bedeutung hat und $R^3$ Alkinyl, unsubstituiertes oder substituiertes Phenylalkinyl, $N_3$, CN, $SiR^4{}_3$ oder $Sn^4{}_3$ ist, und danach die Verbindungen der Formel I in an sich bekannter Weise isoliert.

**15.** Durch Strahlung polymerisierbare Zusammensetzung, enthaltend (a) mindestens eine nichtflüchtige, monomere, oligomere oder polymere Verbindung mit mindestens einer polymerisierbaren äthylenisch ungesättigten Doppelbindung und (b) mindestens ein Titanocen der Formel I nach Anspruch 1 als Photoinitiator.

**16.** Zusammensetzung gemäss Anspruch 15, dadurch gekennzeichnet, dass zusätzlich mindestens ein Photoinitiator (c) enthalten ist.

**17.** Zusammensetzung gemäss Anspruch 16, enthaltend ein Benzilketal, ein 4-Aroyl-1,3-dioxolan, ein Dialkoxyacetophenon, ein $\alpha$-Hydroxy- oder $\alpha$-Aminoacetophenon oder Mischungen davon als zusätzlichen Photoinitiator.

**18.** Verwendung einer Zusammensetzung gemäss Anspruch 16 zur Herstellung von Lacken, Druckfarben, Druckplatten, Resistmaterialien sowie als Bildaufzeichnungsmaterial.

**19.** Beschichtetes Substrat, das auf mindestens einer Oberfläche mit einer Zusammensetzung gemäss Anspruch 15 oder 16 beschichtet ist.

**20.** Verfahren zur photographischen Herstellung von Reliefabbildungen, dadurch gekennzeichnet, dass man ein beschichtetes Substrat gemäss Anspruch 19 bildmässig belichtet und die unbelichteten Anteile danach mit einem Lösungsmittel entfernt.

**21.** Verwendung von Titanocenen der Formel I gemäss Anspruch 1 alleine oder zusammen mit anderen Initiatoren als Photoinitiatoren für die Photopolymerisation von nichtflüchtigen monomeren, oligomeren oder polymeren Verbindungen mit mindestens einer polymerisierbaren ethylenisch ungesättigten Doppelbindung.

**22.** Flüssiges Photoinitiatorengemisch, enthaltend einen Photoinitiator vom Typ der Benzilketale, 4-Aroyl-1,3-dioxolane, Dialkoxyacetophenone, $\alpha$-Hydroxyacetophenone, $\alpha$-Aminoacetophenone oder Mischungen hiervon und ein Titanocen der Formel I gemäss Anspruch 1.

## Claims

**1.** A titanocene of the formula I

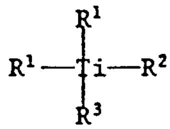

(I)

in which the two radicals $R^1$ independently of one another are cyclopentadienyl$^{\ominus}$, indenyl$^{\ominus}$ or 4,5,6,7-tetrahydroindenyl$^{\ominus}$ unsubstituted or mono- or polysubstituted by $C_1$-$C_{18}$alkyl or $C_1$-$C_{18}$alkoxy, $C_2$-$C_{18}$alkenyl, $C_5$-$C_8$cycloalkyl, $C_6$-$C_{16}$aryl, $C_7$-$C_{16}$aralkyl, cyano or halogen, or the two radicals $R^1$ together are a radical, unsubstituted or substituted as described above, of the formula II

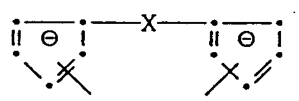

(II)

in which X is $(-CH_2-)_n$, where n is 1, 2 or 3, alkylidene which has 2 to 12 C atoms and is unsubstituted or substituted by phenyl, cycloalkylidene which has 5 to 7 ring carbon atoms, $SiR^4_2$ or $SnR^4_2$ , and $R^4$ is $C_1$-$C_{12}$alkyl, $C_5$-$C_{12}$cycloalkyl, $C_6$-$C_{16}$aryl or $C_7$-$C_{16}$aralkyl, $R^2$ is a 6-membered carbocyclic or 5- or 6-membered heterocyclic aromatic ring which is substituted by fluorine atoms in at least one of the two ortho-positions relative to the metal-carbon bond, it being possible for the aromatic ring to contain as further substituents $C_1$-$C_{18}$alkyl, $C_5$-$C_6$cycloalkyl, $C_6$-$C_{16}$aryl, $C_7$-$C_{16}$aralkyl, hydroxyl, $C_1$-$C_{18}$alkoxy, carboxyl, $C_1$-$C_{18}$alkoxycarbonyl, halogen or cyano, or $R^2$ and $R^3$ together are a radical of the formula III

- Q - Y - Q - (III)

in which Q is a carbocyclic aromatic ring, the two bonds in each case being in the ortho-position relative to the Y group, and the meta-position relative to the Y group in each case being substituted by a fluorine atom, and it being possible for Q to contain as further substituents $C_1$-$C_{18}$alkyl, $C_5$-$C_6$cycloalkyl, $C_6$-$C_{16}$aryl, $C_7$-$C_{16}$aralkyl, hydroxyl, $C_1$-$C_{18}$alkoxy, carboxyl, $C_1$-$C_{18}$alkoxycarbonyl, halogen or cyano, and Y is $CH_2$, alkylidene with 2 to 12 C atoms, cycloalkylidene with 5 to 7 ring carbon atoms, a direct bond, $NR^4$, O, S, SO, $SO_2$, CO, $SiR^4_2$ or $SnR^4_2$ , and $R^4$ is as defined above, $R^3$ has the meaning of $R^2$ or is $C_2$-$C_6$alkynyl, halogen-, tertiary amino-, $C_1$-$C_6$alkoxy-, carboxyl-, OH- or CN-substituted or unsubstituted phenylalkynyl, $N_3$, CN, $SiR^4_3$ or $SnR^4_3$ , in which titanocene $R^2$, and/or $R^3$, if this radical is as defined for $R^2$, and, if $R^2$ and $R^3$ form a radical of the formula III, Q, contains at least one polyoxaalkylene radical of the formula

$$-(C_zH_{2z}O)_o-R^9,$$

in which z is a number from 2-6, o is a number from 1 to 20 and $R^9$ is H, $C_1$-$C_{18}$alkyl or $C_1$-$C_{18}$acyl, which is free, etherified or esterified, it being possible for this radical to be bonded to the aromatic ring either directly or via a bridge group, the bridge group being a group of the formula -S-, -O-, $OSO_2$-, $-CH_2O$-, $-CH(CH_3)O$-, $-SO_2$-, -C(O)O-,

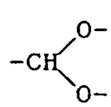

,

-N< , $-NR^{10}$-,

$$-\overset{|}{N}CH_2CH_2N\langle ,$$

$-NR^{10}CH_2CH_2N\langle$ ,

$$-\overset{|}{N}CH_2CH_2-NR^{10}-,$$

$-NR^{10}CH_2CH_2NR^{10}-$, $-CH_2N\langle$ , $-CH_2NR^{10}-$, $-CH(COO-)_2$, $-CH_2COO-$, $-CONR^{10}-$, $-CH(CONR^{10}-)_2$, $-CH_2CONR^{10}-$, $-CON\langle$ , -OC(O)O-, $-N(R^{10})-COO-$, $-CH_2N(R^{10})-COOH-$, $-N(R^{10})-CONH-$, $-CH_2N(R^{10})-CONH-$ or $-C_nH_{2n}OC(O)C_mH_{2m}O-$ where n = 0, 1 or 2 and m = 1-6,

$$-C_nH_{2n}OSiR^{11}_{3-y}O_y-,$$

where n = 0, 1 or 2 and y = 1-3, or

$$-OCH_2CH_2OSiR^{11}_{3-y}O_y-,\quad -COOSiR^{11}_{3-y}O_y- \text{ or } -CH_2COOSiR^{11}_{3-y}O_y-$$

where y = 1-3, in which $R^{10}$ is H, $C_1$-$C_{18}$alkyl or $C_1$-$C_{18}$acyl and $R^{11}$ is $C_1$-$C_{12}$alkyl or phenyl.

**2.** A titanocene according to claim 1, in which $R^1$ is cyclopentadienyl$^{\ominus}$ or methylcyclopentadienyl$^{\ominus}$.

**3.** A titanocene according to claim 1, in which $R^2$ and $R^3$ have the same meaning.

**4.** A titanocene according to claim 1, in which $R^2$ and $R^3$ are 2,6-difluorophen-1-yl, to which at least one free or etherified polyoxaalkylene radical is bonded directly or via a bridge group and which can contain 1 or 2 further identical or different substituents.

**5.** A titanocene according to claim 4, in which, in formula I, the two radicals $R^1$ are cyclopentadienyl$^{\ominus}$ or cyclopentadienyl$^{\ominus}$ which is substituted by $C_1$-$C_4$alkyl and $R^2$ and $R^3$ are radicals of the formula

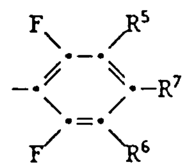

in which $R^5$ and $R^6$ independently of one another are H, F, Cl or Br and $R^7$ is polyoxaalkylene which is free, etherified or esterified and is bonded to the phenyl ring directly or via a bridge group.

**6.** A titanocene according to claim 1, in which the polyoxaalkylene radical is etherified with $C_1$-$C_{18}$alkyl or esterifed with $C_1$-$C_{18}$acyl.

**7.** A titanocene according to claim 1, in which the polyoxaalkylene radical contains 1 to 20 oxaalkylene units.

**8.** A titanocene according to claim 1, in which the alkylene in the polyoxaalkylene radical contains 2 to 6 C atoms.

**9.** A titanocene according to claim 8, in which the alkylene is ethylene or 1,2-propylene.

**10.** A titanocene according to claim 1, in which $R^9$ is $C_1$-$C_{12}$alkyl, $R^{10}$ is H or $C_1$-$C_{12}$alkyl and $R^{11}$ is $C_1$-$C_6$alkyl, z is a number from 2 to 4 and o is a number from 2 to 6.

**11.** A titanocene according to claim 10, in which the polyoxaalkylene radical is etherified and, together with the bridge group, corresponds to one of the formulae

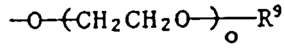

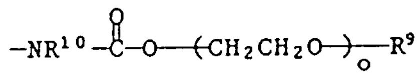

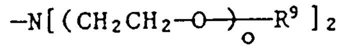

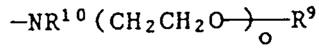

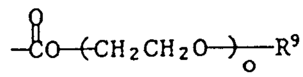

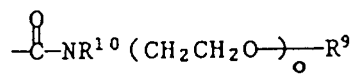

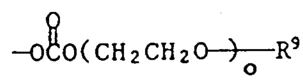

in which $R^9$ is $C_1$-$C_{12}$alkyl, $R^{10}$ is H or $C_1$-$C_6$alkyl and o is a number from 2 to 6.

**12.** A titanocene according to claim 1 of the formula I, in which $R^1$ is cyclopentadienyl$^{\ominus}$ or methylcyclopentadienyl$^{\ominus}$ and $R^2$ and $R^3$ are radicals of the formula

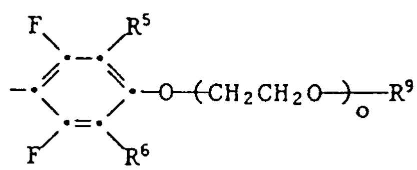

in which $R^5$ and $R^6$ are hydrogen or fluorine, o is a number from 2 to 6 and $R^9$ is $C_1$-$C_{12}$alkyl.

**13.** A titanocene according to claim 12, in which $R^5$ and $R^6$ are fluorine.

**14.** A process for the preparation of a titanocene of the formula I according to claim 1, which comprises reacting 1 mol of a compound of the formula III

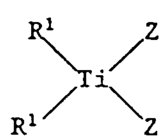

(III)

in which $R^1$ is as defined in claim 1 and Z is halogen, in particular chlorine, either with one mol of $LiR^2$ or $LiR^3$ and then with one mol of $LiR^3$ and $LiR^2$ respectively, or with 2 mol of $LiR^2$, in which $R^2$ is as defined in claim 1 and $R^3$ is alkynyl, unsubstituted or substituted phenylalkynyl, $N_3$, CN, $SiR^4_3$ or $SnR^4_3$, and then isolating the compound of the formula I in a manner which is known per se.

**15.** A composition which can be polymerised by radiation, containing (a) at least one non-volatile monomeric, oligomeric or polymeric compound with at least one polymerizable ethylenically unsaturated double bond and (b) at least one titanocene of the formula I according to claim 1 as a photoinitiator.

**16.** A composition according to claim 15, which additionally contains at least one photoinitiator (c).

**17.** A composition according to claim 16 containing a benzil ketal, a 4-aroyl-1,3-dioxolane, a dialkoxyacetophenone, an α-hydroxy- or α-aminoacetophenone or a mixture thereof as an additional photoinitiator.

**18.** The use of a composition according to claim 16 for the production of varnishes, printing inks, printing plates and resist materials and as an image recording material.

**19.** Coated substrate which is coated on at least one surface with a composition according to claim 15 or 16.

**20.** A process for the photographic production of a relief image, which comprises exposing a coated substrate according to claim 19 imagewise and then removing the non-exposed portions with a solvent.

**21.** The use of a titanocene of the formula I according to claim 1, by itself or together with other initiators, as a photoinitiator for the photopolymerization of non-volatile monomeric, oligomeric or polymeric compounds with at least one polymerizable ethylenically unsaturated double bond.

**22.** A liquid photoinitiator mixture containing a photoinitiator of the benzil ketal, 4-aroyl-1,3-dioxolane, dialkoxyacetophenone, α-hydroxyacetophenone or α-aminoacetophenone type or a mixture thereof and a titanocene of the formula I according to claim 1.

## Revendications

**1.** Titanocènes de formule I

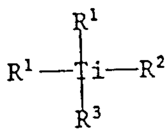

(I),

dans laquelle les radicaux $R^1$, indépendamment l'un de l'autre, sont des radicaux cyclopentadiényle⁻, indényle⁻, tétrahydro-4,5,6,7 indényle⁻ éventuellement une ou plusieurs fois substitués par des radicaux alkyle ou alcoxy en $C_1$-$C_{18}$, alcényle en $C_2$-$C_{18}$, cycloalkyle en $C_5$-$C_8$, aryle en $C_6$-$C_{16}$, aralkyle en $C_7$-$C_{16}$, cyano ou halogéno, ou encore les deux radicaux $R^1$ représentent ensemble un radical éventuellement substitué comme ci-dessus, de formule II

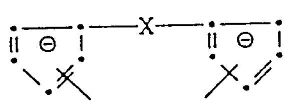

(II)

dans laquelle X est $-(CH_2)_n-$, avec n = 1, 2 ou 3, un radical alkylidène ayant de 2 à 12 atomes de carbone et éventuellement substitué par des radicaux phényle, cycloalkylidène ayant de 5 à 7 atomes de carbone nucléaires, $SiR^4{}_2$ ou $SnR^4{}_2$, et $R^4$ est un radical alkyle en $C_1$-$C_{12}$, cycloalkyle en $C_5$-$C_{12}$, aryle en $C_6$-$C_{16}$ ou aralkyle en $C_7$-$C_{16}$,

$R^2$ est un radical aromatique carbocyclique à 6 chaînons ou hétérocyclique à 5 ou 6 chaînons, qui est substitué par des atomes de fluor sur au moins l'une des deux positions ortho par rapport à la liaison métal-carbone, le noyau aromatique pouvant contenir comme autres substituants des radicaux alkyle en $C_1$-$C_{18}$, cycloalkyle en $C_5$-$C_6$, aryle en $C_6$-$C_{16}$, aralkyle en $C_7$-$C_{16}$, hydroxyle, alcoxy en $C_1$-$C_{18}$, carboxyle, (alcoxy en $C_1$-$C_{18}$)-carbonyle, halogéno ou cyano, ou encore $R^2$ et $R^3$ représentent ensemble un radical de formule III

-Q-Y-Q- (III)

dans laquelle Q représente un noyau aromatique carbocyclique, chacune des deux liaisons étant en position ortho par rapport au groupe Y, et chaque position méta par rapport au groupe Y étant substituée par un atome de fluor, et où Q peut contenir en tant qu'autres substituants des radicaux alkyle en $C_1$-$C_{18}$, cycloalkyle en $C_5$-$C_6$, aryle en $C_6$-$C_{16}$, aralkyle en $C_7$-$C_{16}$, hydroxyle, alcoxy en $C_1$-$C_{18}$, carboxyle, (alcoxy en $C_1$-$C_{18}$)-carbonyle, halogéno ou cyano, Y est $CH_2$ ou un radical alkylidène ayant de 2 à 12 atomes de carbone, cycloalkylidène ayant de 5 à 7 atomes de carbone nucléaires, une liaison directe, $NR^4$, O, S, SO, $SO_2$, CO, $SiR^4{}_2$ ou $SnR^4{}_2$, et $R^4$ a la signification donnée ci-dessus,

$R^3$ a la signification de $R^2$ ou est un radical alcynyle en $C_2$-$C_6$, un radical phénylalcynyle non substitué, ou substitué par des radicaux halogéno, amino tertiaire, alcoxy en $C_1$-$C_6$, carboxyle, OH ou CN, ou encore $N_3$, CN, $SiR^4{}_3$ ou $SnR^4{}_3$, où les titanocènes sont caractérisés en ce que $R^2$ et/ou $R^3$, dans la mesure où ce radical a une signification telle que donnée pour $R^2$, et, si $R^2$ et $R^3$ forment un radical de formule III, le radical Q, contiennent au moins un radical polyoxaalkylène éventuellement éthérifié ou estérifié de formule $-(C_zH_{2z}O)_o-R^9$, où z est un nombre de 2-6, o un nombre de 1-20 et $R^9$ est H ou un radical alkyle en $C_1$-$C_{18}$ ou acyle en $C_1$-$C_{18}$, ce radical pouvant être lié au noyau aromatique directement ou par l'intermédiaire d'un groupe pontant, auquel cas, pour ce qui est du groupe pontant, il s'agit d'un groupe de formule -S-, -O-, $-OSO_2-$, $-CH_2O-$, $-CH(CH_3)O-$, $-SO_2-$, -C(O)O-,

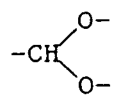 ,

-N< , $-NR^{10}-$,

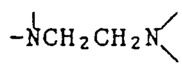 ,

$-NR^{10}CH_2CH_2N$< ,

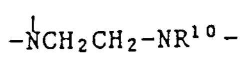 ,

$-NR^{10}CH_2CH_2NR^{10}-$, $-CH_2N$< , $-CH_2NR^{10}-$, $-CH(COO-)_2$, $-CH_2COO-$, $-CONR^{10}-$, $-CH(CONR^{10}-)_2$, $-CH_2CONR^{10}-$, -CON< , -OC(O)O-, $-N(R^{10})-COO-$, $-CH_2N(R^{10})-COOH-$, $-N(R^{10})-CONH-$, $-CH_2N(R^{10})-CONH-$, $C_nH_{2n}OC(O)C_mH_{2m}O$-avec n = 0, 1 ou 2 et m = 1-6, $-C_nH_{2n}OSiR^{11}{}_{3-y}O_y-$ avec n = 0, 1 ou 2 et y = 1-3, $-OCH_2CH_2OSiR^{11}{}_{3-y}O_y-$, $-COOSiR^{11}{}_{3-y}O_y-$ ou $-CH_2COOSiR^{11}{}_{3-y}O_y-$ avec y = 1-3, où $R^{10}$ est H, un radical alkyle en $C_1$-$C_{18}$ ou acyle en $C_1$-$C_{18}$, et $R^{11}$ est un radical alkyle en $C_1$-$C_{12}$ ou phényle.

**2.** Titanocènes selon la revendication 1, caractérisés en ce que $R^1$ est le radical cyclopentadiényle$^-$ ou méthylcyclopentadiényle$^-$.

**3.** Titanocènes selon la revendication 1, caractérisés en ce que $R^2$ et $R^3$ ont la même signification.

**4.** Titanocènes selon la revendication 1, caractérisés en ce que $R^2$ et $R^3$ représentent chacun le radical difluoro2,6 phényle-1, auquel au moins un radical polyoxaalkylène éventuellement éthérifié est lié directement ou par l'intermédiaire d'un groupe pontant, et qui peut contenir encore 1 ou 2 autres substituants identiques ou différents.

**5.** Titanocènes selon la revendication 4, caractérisés en ce que, dans la formule I, les deux radicaux $R^1$ sont des radicaux cyclopentadiényle$^-$ ou cyclopentadiényle$^-$ substitué par des radicaux alkyle en $C_1$-$C_4$, et $R^2$ et $R^3$ sont des radicaux de formule

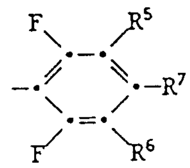

dans laquelle $R^5$ et $R^6$, indépendamment l'un de l'autre, sont chacun H, F, Cl ou Br, et $R^7$ est un radical polyoxaalkylène éventuellement éthérifié ou estérifié, lié au noyau phénylique directement ou par l'intermédiaire d'un groupe pontant.

**6.** Titanocènes selon la revendication 1, caractérisés en ce que le radical polyoxaalkylène est éthérifié avec un radical alkyle en $C_1$-$C_{18}$ ou est estérifié avec un radical acyle en $C_1$-$C_{18}$.

**7.** Titanocènes selon la revendication 1, caractérisés en ce que le radical polyoxaalkylène contient de 1 à 20 motifs oxaalkylène.

**8.** Titanocènes selon la revendication 1, caractérisés en ce que le fragment alkylène du radical polyoxaalkylène contient de 2 à 6 atomes de carbone.

**9.** Titanocènes selon la revendication 8, caractérisés en ce que l'alkylène est l'éthylène ou le propylène-1,2.

**10.** Titanocènes selon la revendication 1, caractérisés en ce que $R^9$ est un radical alkyle en $C_1$-$C_{12}$, $R^{10}$ est H ou un radical alkyle en $C_1$-$C_{12}$ et $R^{11}$ est un radical alkyle en $C_1$-$C_6$, z est un nombre de 2 à 4 et o est un nombre de 2 à 6.

**11.** Titanocènes selon la revendication 10, caractérisés en ce que le radical polyoxaalkylène est éthérifié et, avec le groupe pontant, correspond à l'une des formules suivantes :

$$-O-(CH_2CH_2O)_o-R^9$$

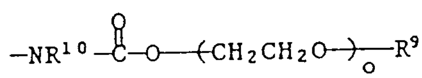

$$-N[(CH_2CH_2-O)_o-R^9]_2$$

$$-NR^{10}(CH_2CH_2O)_o-R^9$$

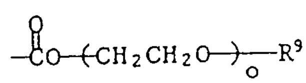

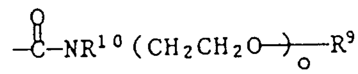

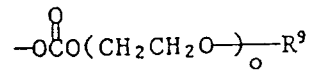

où $R^9$ est un radical alkyle en $C_1$-$C_{12}$, $R^{10}$ est H ou un radical alkyle en $C_1$-$C_6$, et o représente un nombre de 2 à 6.

**12.** Titanocènes selon la revendication 1 de formule I, où $R^1$ est le radical cyclopentadiényle$^-$ ou méthylcyclopentadiényle$^-$, et $R^2$ et $R^3$ sont des radicaux de formule

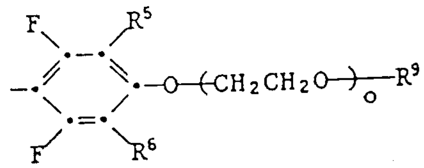

où $R^5$ et $R^6$ sont chacun un hydrogène ou un fluor, o est un nombre de 2 à 6 et $R^9$ est un radical alkyle en $C_1$-$C_{12}$.

**13.** Titanocènes selon la revendication 12, dans lesquels $R^5$ et $R^6$ sont chacun le fluor.

**14.** Procédé pour préparer des titanocènes de formule I selon la revendication 1, caractérisé en ce qu'on fait réagir 1 mole d'un composé de formule III

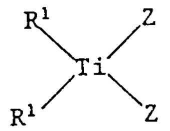

(III),

dans laquelle $R^1$ a la signification indiquée ci-dessus et Z est un halogène, en particulier le chlore, avec une mole de $LiR^2$ ou de $LiR^3$ puis avec une mole respectivement de $LiR^3$ et de $LiR^2$, ou encore on la fait réagir avec 2 moles de $LiR^2$, où $R^2$ a la signification donnée ci-dessus et $R^3$ est un radical alcynyle, phénylacynyle éventuellement substitué, $N_3$, CN, $SiR^4{}_3$ ou $SnR^4{}_3$, puis, d'une manière connue en soi, on isole les composés de formule I.

**15.** Composition polymérisable sous l'effet d'un rayonnement, contenant (a) au moins un composé monomère, oligomère ou polymère non volatil comportant au moins une double liaison polymérisable à insaturation éthylénique, et (b) au moins un titanocène de formule I selon la revendication 1 en tant que photoamorceur.

**16.** Composition selon la revendication 15, caractérisée en ce qu'elle contient en outre au moins un autre photoamorceur (c).

**17.** Composition selon la revendication 16, contenant un benzylcétal, un aroyl-4 dioxolanne-1,3, une dialcoxyacétophénone, une $\alpha$-hydroxy- ou une $\alpha$-aminoacétophénone ou leurs mélanges, comme photoamorceur supplémentaire.

**18.** Utilisation d'une composition selon la revendication 16 pour préparer des vernis, des encres d'imprimerie, des clichés d'impression, des matériaux de réserve, et servant aussi de matériau d'enregistrement d'images.

**19.** Substrat enduit, enduit sur au moins une surface d'une composition selon la revendication 15 ou 16.

**20.** Procédé pour préparer par voie photographique des images en relief, caractérisé en ce qu'on expose selon l'image un substrat enduit selon la revendication 19, puis qu'on élimine avec un solvant les zones non exposées.

**21.** Utilisation de titanocènes de formule I selon la revendication 1, seuls ou avec d'autres amorceurs, en tant que photoamorceurs pour la photopolymérisation de composés monomères, oligomères ou polymères non volatils comportant au moins une double liaison polymérisable à insaturation éthylénique.

**22.** Mélange de photoamorceurs liquides, contenant un photoamorceur de la classe comprenant les benzylcétals, les aroyl-4 dioxolannes-1,3, les dialcoxyacétophénones, les $\alpha$-hydroxyacétophénones, les $\alpha$-aminoacétophénones ou leurs mélanges, et un titanocène de formule I selon la revendication 1.